(19) Europäisches Patentamt
European Patent Office
Office européen des brevets

(11) **EP 3 233 578 B1**

(12) **EUROPÄISCHE PATENTSCHRIFT**

(45) Veröffentlichungstag und Bekanntmachung des Hinweises auf die Patenterteilung:
**02.01.2019   Patentblatt 2019/01**

(51) Int Cl.:
***B60R 21/01*** *(2006.01)*          ***B60R 21/017*** *(2006.01)*

(21) Anmeldenummer: **15787554.3**

(86) Internationale Anmeldenummer:
**PCT/EP2015/074884**

(22) Anmeldetag: **27.10.2015**

(87) Internationale Veröffentlichungsnummer:
**WO 2016/096213 (23.06.2016 Gazette 2016/25)**

(54) **ÜBERWACHUNGSVORRICHTUNG FÜR ZUMINDEST EINEN ZÜNDKREIS FÜR EIN PERSONENSCHUTZMITTEL FÜR EIN FAHRZEUG UND VERFAHREN ZUM BETREIBEN EINER ÜBERWACHUNGSVORRICHTUNG**

MONITORING DEVICE FOR AT LEAST ONE IGNITION CIRCUIT FOR A PERSONAL PROTECTION MEANS FOR A VEHICLE, AND METHOD FOR OPERATING A MONITORING DEVICE

DISPOSITIF DE SURVEILLANCE POUR AU MOINS UN CIRCUIT D'ALLUMAGE POUR UN MOYEN DE PROTECTION DE PERSONNES POUR UN VÉHICULE, ET PROCÉDÉ SERVANT À FAIRE FONCTIONNER UN DISPOSITIF DE SURVEILLANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.12.2014   DE 102014225960**

(43) Veröffentlichungstag der Anmeldung:
**25.10.2017   Patentblatt 2017/43**

(73) Patentinhaber: **Robert Bosch GmbH**
**70442 Stuttgart (DE)**

(72) Erfinder:
• **KARNER, Ruediger**
**70806 Kornwestheim (DE)**
• **SCHUMACHER, Hartmut**
**71691 Freiberg (DE)**

(56) Entgegenhaltungen:
**EP-A1- 1 582 417**

**Beschreibung**

Stand der Technik

Die vorliegende Erfindung bezieht sich auf eine Überwachungsvorrichtung für zumindest einen Zündkreis für ein Personenschutzmittel für ein Fahrzeug, auf ein entsprechendes Verfahren zum Betreiben einer Überwachungsvorrichtung, auf ein entsprechendes Steuergerät sowie auf ein entsprechendes Computerprogramm.

Insassenschutzsysteme verfügen über eine Zündkreisanordnung, welche mindestens einen Zündkreis zur Aktivierung von Rückhaltemitteln aufweist. Die heutige Zündkreis-Überwachung besteht aus der Nebenschluss-Erkennung an den Versorgungsanschlüssen des Zündkreises sowie einer Widerstandsmessung der Zündkreis-Schleife. Des Weiteren ist ein Verkopplungstest implementiert, um zu erkennen, ob ein Zündkreis mit einem anderen Zündkreis oder anderen Steuergeräte-Ein-/Ausgängen verkoppelt ist.

Aufgabe der Erfindung ist es, den heutigen Stand weiter zu verbessern und platzsparender in den Zündkreis oder System-ASICs zu integrieren.

Offenbarung der Erfindung

Vor diesem Hintergrund werden mit dem hier vorgestellten Ansatz eine Überwachungsvorrichtung für zumindest einen Zündkreis für ein Personenschutzmittel für ein Fahrzeug, weiterhin ein Verfahren zum Betreiben der Überwachungsvorrichtung, welches die Überwachungsvorrichtung für zumindest einen Zündkreis für ein Personenschutzmittel für ein Fahrzeug verwendet, ein entsprechendes Steuergerät, welches das Verfahren nutzt, sowie schließlich ein entsprechendes Computerprogramm gemäß den Hauptansprüchen vorgestellt. Vorteilhafte Ausgestaltungen ergeben sich aus den jeweiligen Unteransprüchen und der nachfolgenden Beschreibung.

Durch zumindest eine Stromquelle mit einer Leerlaufspannung in der Größe oder über einer realen, maximalen Zündspannung können in einem gesamten Spannungsbereich einer Zündkreisaktivierung Fehlerfälle erkannt werden, die erst mit Überschreiten einer relevanten Spannungsschwelle auftreten, wie beispielsweise Kontaktoxide, über Dioden gekoppelte Fahrzeugspannungen oder Schutzelemente.

Es wird eine Überwachungsvorrichtung für zumindest einen Zündkreis für ein Personenschutzmittel für ein Fahrzeug vorgestellt, wobei der zumindest eine Zündkreis ausgebildet ist, das Personenschutzmittel bei Anliegen einer einen Spannungsschwellwert übersteigenden Zündspannung und/oder eines einen Stromschwellwert übersteigenden Zündstroms zu aktivieren, wobei die Überwachungsvorrichtung eine Steuereinrichtung und eine über einen Spannungsquellenanschluss der Steuereinrichtung verbundene Spannungsquelle aufweist, wobei die Steuereinrichtung über einen High-Side-Zündkreisanschluss mit einem ersten Versorgungsanschluss des Zündkreises und über einen Low-Side-Zündkreisanschluss mit einem zweiten Versorgungsanschluss des Zündkreises verbunden ist, dadurch gekennzeichnet, dass die Überwachungsvorrichtung derart ausgebildet ist, dass eine Leerlaufspannung einer zwischen dem Spannungsquellenanschluss und dem High-Side-Zündkreisanschluss angeordneten High-Side-Stromquelle der Steuereinrichtung zumindest dem Spannungsschwellwert entspricht, insbesondere dass die Leerlaufspannung zumindest einer maximalen Zündspannung des Zündkreises entspricht.

Ein Fahrzeug kann ein Personenschutzmittel wie beispielsweise einen Airbag oder einen Gurtstraffer aufweisen. Das Personenschutzmittel kann über einen Zündkreis aktiviert werden. In dem Zündkreis kann eine Zündpille bei Anliegen einer eingebrachten Leistung, die einen vorbestimmten Leistungsschwellwert übersteigt, aktiviert oder gezündet werden. Die Überwachungsvorrichtung kann als eine integrierte elektrische Schaltung oder als ein sogenannter System-ASIC umgesetzt sein. Die Steuereinrichtung der Überwachungsvorrichtung kann als eine integrierte elektrische Schaltung, eine anwendungsspezifische integrierte Schaltung oder als ein sogenannter System-ASIC umgesetzt sein. So kann unter der Überwachungsvorrichtung eine Zündkreis-Überwachung oder eine erweiterte Zündkreisüberwachung verstanden werden. Unter dem Spannungsquellenanschluss, einem Spannungssenkenanschluss, dem High-Side-Zündkreisanschluss und dem Low-Side-Zündkreisanschluss können Anschlüsse, Anschluss-Pins, ASIC-Pins oder Schnittstellen der Überwachungsvorrichtung oder der Steuereinrichtung verstanden werden. Unter der Spannungsquelle kann eine Energiereserve oder eine verpolgeschützte Energiereservespannung verstanden werden. Die Spannungsquelle kann aus einem Bordnetz des Fahrzeugs gespeist werden. Die Spannungsquelle kann eine Spannung von zumindest 24 V, insbesondere zumindest 30 V, insbesondere zumindest 42 V bereitstellen. Die Spannungsquelle kann eine Spannung in einem Bereich von 24 V bis 42 V bereitstellen. Der Zündkreis weist einen ersten Versorgungsanschluss und einen zweiten Versorgungsanschluss auf. Unter dem ersten Versorgungsanschluss kann ein erster Zündkreisanschluss, ein ZK1+-Anschluss, ein Zündkreis-Plus-Anschluss oder ein Zündkreis-Plus-Steuergeräteanschluss verstanden werden. Unter dem zweiten Versorgungsanschluss kann ein Zündkreisanschluss, ein ZK1--Anschluss, ein Zündkreis-Minus-Anschluss oder ein Zündkreis-Minus-Steuergeräteanschluss verstanden werden. Zwischen dem High-Side-Zündkreisanschluss und der High-Side-Stromquelle kann ein High-Side-Multiplexer angeordnet sein.

Günstig ist es auch, wenn die Leerlaufspannung der High-Side-Stromquelle zumindest 26 Volt, insbesondere zumindest 30 Volt, insbesondere zumindest 36 Volt, insbesondere zumindest 42 Volt beträgt. So kann die Spannung zwischen dem High-Side-Zündkreisanschluss und dem Low-Side-Zündkreisanschluss zumindest 26 Volt, insbesondere zumindest 30 Volt, insbesondere zumindest 36 Volt, insbesondere zumindest 42 Volt betragen. Vorteilhaft kann eine durch OxidSchichten im Zündkreislauf verschlechterte Kontaktverbindung verbessert werden, da ein Oxiddurchschlag ermöglicht werden kann.

Die Überwachungsvorrichtung kann eine Stromquellen-Steuereinrichtung aufweisen, die ausgebildet ist, einen zeitlichen Verlauf eines Stromanstiegs der High-Side-Stromquelle beim Übergang von einem ersten Stromniveau auf ein zweites Stromniveau entsprechend einer vordefinierten Übergangsform zu steuern. Unter der Stromquellen-Steuereinrichtung kann eine erste Stromquellen-Steuereinrichtung oder eine High-Side-Stromquellen-Steuereinrichtung verstanden werden. Insbesondere kann die Stromquellen-Steuereinrichtung den zeitlichen Verlauf des Stromanstiegs entsprechend einer Übergangsform mit einem Verlauf eines "Raised-Cosinus" steuern. So kann einfach eine Flankenformung des Messstromimpulses erfolgen. So kann der zeitliche Verlauf des Stromanstiegs entsprechend einem Raised-Cosine-Filter, auch als Kosinus-Roll-off-Filter bezeichnet, zur Formung des Messstroms verwendet werden. So kann der zeitliche Verlauf des Stromanstiegs die erste Nyquistbedingung erfüllen. Vorteilhaft kann eine Abstrahlung oder ein EMV-Verhalten der Überwachungsvorrichtung durch die stufenweise Erhöhung des Messstroms verbessert werden.

Ferner kann die Überwachungsvorrichtung eine Filtereinrichtung zum Filtern zumindest einer Messspannung (insbesondere zwischen dem High-Side-Zündkreisanschluss und dem Low-Side-Zündkreisanschluss) aufweisen. Insbesondere kann die Filtereinrichtung zumindest einen Tiefpassfilter umfassen. Hierdurch lassen sich Messungenauigkeiten, beispielsweise durch Schaltvorgänge und/oder Aufladungen von Kapazitäten oder Induktivitäten der Vorrichtung vermeiden oder deren Wirkung reduzieren.

Die Überwachungsvorrichtung kann einen Analog-Digital-Wandler umfassen, der über einen ADC-Multiplexer mit einem Instrumentenverstärker verbunden ist. Der Analog-Digital-Wandler kann mit dem ADC-Multiplexer zur Messung einer Spannung über einen Tiefpassfilter zwischen dem High-Side-Zündkreisanschluss und dem Low-Side-Zündkreisanschluss für den zumindest einen Zündkreis und zwischen einem Zündkreisverstärkungs-Anschluss und Analogmasseanschluss beziehungsweise zwischen einem Offset-Anschluss und dem Analogmasseanschluss verwendet werden.

Ein Strom-Limitierungswiderstand kann zwischen der Spannungsquelle und dem Spannungsquellenanschluss angeordnet sein. Ein Strom-Limitierungswiderstand kann zwischen dem Masseanschluss und einem Spannungssenkenanschluss angeordnet sein. Die Strom-Limitierungswiderstände können extern zur Steuereinrichtung angeordnet sein. So kann vorteilhaft die Sicherheit gegen Fehler der Überwachungsvorrichtung verbessert werden.

Die Überwachungsvorrichtung kann ferner einen schaltbaren High-Side-Terminierungswiderstand und ergänzend oder alternativ einen schaltbaren Low-Side-Terminierungswiderstand aufweisen. Insbesondere kann zwischen einem Ausgang eines mit der High-Side-Stromquelle verbundenen High-Side-Multiplexers und dem Spannungssenkenanschluss der schaltbare High-Side-Terminierungswiderstand und ergänzend oder alternativ zwischen einem Ausgang eines mit dem Low-Side-Zündkreisanschluss verbundenen Low-Side-Multiplexers und dem Spannungssenkenanschluss der schaltbare Low-Side-Terminierungswiderstand angeordnet sein. Vorteilhaft kann eine Genauigkeit der Messung verbessert werden, wenn die Terminierungswiderstände während der Messung abgeschaltet werden. So kann durch eine Widerstandsreferenzmessung nach Masse ein Offset der Überwachungsvorrichtung bestimmt oder kompensiert werden.

Die Überwachungsvorrichtung kann ferner einen schaltbaren High-Side-Spannungsteiler und ergänzend oder alternativ einem schaltbaren Low-Side-Spannungsteiler aufweisen. Insbesondere kann zwischen einem Ausgang eines mit der High-Side-Stromquelle verbundenen High-Side-Multiplexers und einem mit einem Analog-Digital-Wandler verbundenen ADC-Multiplexer der schaltbare High-Side-Spannungsteiler und ergänzend oder alternativ zwischen einem Ausgang eines mit dem Low-Side-Zündkreisanschluss verbundenen Low-Side-Multiplexers und dem ADC-Multiplexer der schaltbare Low-Side-Spannungsteiler angeordnet sein. Auf diese Weise kann mit technisch einfachen Mitteln eine Kalibrierung der Überwachungsvorrichtung erfolgen.

Es wird ein Verfahren zum Betreiben einer Variante einer hier beschriebenen Überwachungsvorrichtung vorgestellt, wobei das Verfahren zumindest die folgenden Schritte aufweist:

Verbinden von High-Side-Zündkreisanschluss mit der High-Side-Stromquelle und Verbinden von Low-Side-Zündkreisanschluss mit einem Spannungssenkenanschluss;

Aktivieren der High-Side-Stromquelle;

Bestimmen eines Differenzspannungssignals zwischen dem High-Side-Zündkreisanschluss und dem Low-Side-Zündkreisanschluss; und

Ermitteln eines Zündkreiswiderstands unter Verwendung des Differenzspannungssignals.

Auch durch diese Ausführungsvariante der Erfindung in Form eines Verfahrens kann die der Erfindung zugrunde liegende Aufgabe schnell und effizient gelöst werden.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern beziehungsweise umzusetzen. Auch durch diese Ausführungsvariante der Erfindung in Form eines Steuergeräts kann die der Erfindung zugrunde liegende Aufgabe schnell und effizient gelöst werden. Das Steuergerät kann dabei ein Teil der zuvor beschriebenen Steuereinrichtung sein oder mit dieser verbunden sein.

Unter einem Steuergerät kann vorliegend ein elektrisches Gerät verstanden werden, das Sensorsignale verarbeitet und in Abhängigkeit davon Steuerund/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Mit anderen Worten können Stromquellen mit Leerlaufspannungen in der Größe oder über den realen maximalen Zündspannungen eingesetzt werden, um im gesamten Spannungsbereich einer Zündkreisaktivierung alle Fehlerfälle, die erst mit Überschreiten einer relevanten Spannungsschwelle, oder Kontaktoxide, über Dioden gekoppelte Fahrzeugspannungen, Schutzelemente etc. erkennbar wären, zu erkennen. Vorteilhaft können relevante steuergerät-externe Nebenschlüsse an den Zündkreisen erkannt werden, und somit steuergerät-interne Fehler beim Prüfen der Zündkreis-Endstufen vermieden werden. Ein Tauschen eines Steuergeräts aufgrund eines externen Fehlers kann vermieden werden. Weiterhin können oxidierte Kontakte im Nebenschluss erkannt werden und somit ein Versagen im Aktivierungsfall vermieden werden. Fehler in der Zündkreis-Messung und eine unsichere Zündung im Aktivierungsfall durch oxidierte Kontakte in der Zündschleife können vermieden werden. Kurzschlüsse gegen entkoppelte (Dioden-) Spannungen, die zu Versagen im Aktivierungsfall führen könnten, können erkannt werden.

Eine Abstrahlung der Überwachungsvorrichtung kann durch eine Flankenformung ("Raised Cosine") des Messstrompulses verbessert. Die Abstrahlung kann durch eine stufenweise Erhöhung des Messstromes verbessert werden. Vorteilhaft kann eine Störfestigkeit durch eine zentrale Filterung der Messspannungen erhöht werden. Vorteilhaft kann die Sicherheit der ZündkreisMessung gegen Fehler der eigenen Messeinrichtung und in Folge Fehlauslösung durch eine ASIC-externe Stromlimitierung auf der High-Seite und Low-Seite mit integrierter Überwachung verbessert werden. Die Genauigkeit der Zündkreis-Widerstandsmessung kann durch Abschaltung von Terminierungswiderständen oder Teilern an den Zündkreisen während der Messung verbessert werden. Ebenso kann durch zusätzliche Verwendung einer Widerstandsreferenzmessung nach Masse der Offset in der Messeinrichtung kompensiert werden. Durch Einbeziehung einer zur Anbindung der ASIC-Zündkreise an den Gerätestecker äquivalenten Zündkreisleiterbahn (Hinleitung und Rückleitung) auf der Leiterplatte in den Feinabgleich der ASIC-Widerstandsmessung kann die Genauigkeit trotz hochohmiger Anbindung der Zündkreise mit schmalen (100 bis 200 $\mu$m breiten) Leiterbahnen in den Innenlagen kompakterer Designs kompensiert werden.

Der hier vorgestellte Ansatz wird nachstehend anhand der beigefügten Zeichnungen beispielhaft näher erläutert. Es zeigen:

Fig. 1 bis Fig. 4 je einen vereinfachten Schaltplan einer Zündkreisüberwachung gemäß einem Ausführungsbeispiel der vorliegenden Erfindung; und

Fig. 5 eine schematische Darstellung eines Fahrzeugs mit einem Personenschutzmittel und einer Überwachungsvorrichtung gemäß einem Ausführungsbeispiel der vorliegenden Erfindung; und

Fig. 6 ein Ablaufdiagramm eines Verfahrens gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

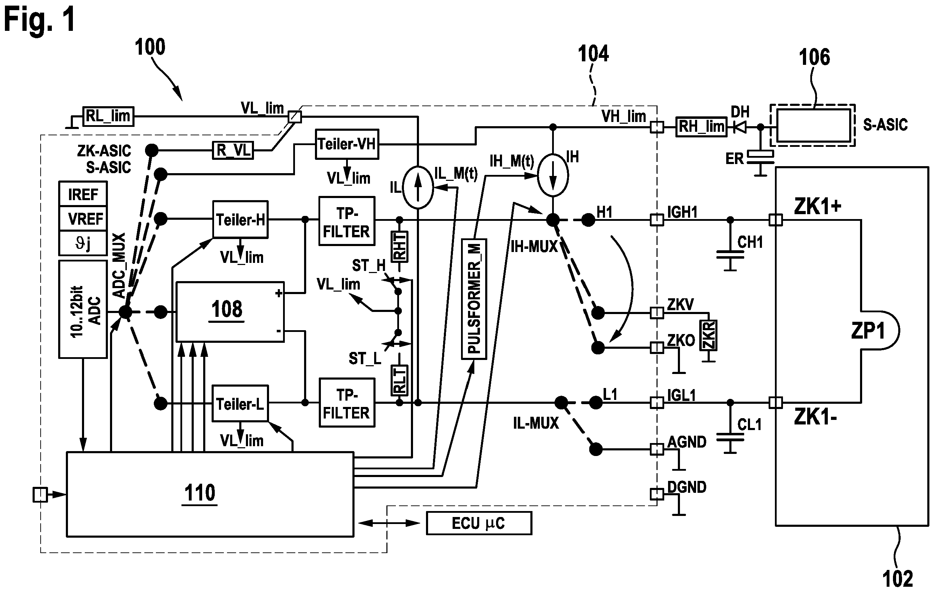

Fig. 1 zeigt einen vereinfachten Schaltplan einer Überwachungsvorrichtung 100 gemäß einem Ausführungsbeispiel der vorliegenden Erfindung. Bei der Überwachungsvorrichtung 100 handelt es sich um eine Überwachungsvorrichtung 100 für einen Zündkreis 102 für ein Personenschutzmittel für ein Fahrzeug, die somit auch im Folgenden als Zündkreisüberwachung bezeichnet wird. In Fig. 1 ist der prinzipielle Aufbau einer Zündkreis-Widerstandsmessung für einen einzelnen Zündkreis 102 als integrierte Lösung eines Airbag-Zündkreis-ASICs oder Airbag-System-ASICs dargestellt. Der Zündkreis 102 ist ausgebildet, das Personenschutzmittel bei Anliegen einer einen Spannungsschwellwert übersteigenden Zündspannung und eines einen Stromschwellwert übersteigenden Zündstroms, das heißt bei Anliegen einer einen Leistungsschwellwert übersteigenden Zündleistung, zu aktivieren.

Die Überwachungsvorrichtung 100 umfasst zumindest eine Steuereinrichtung 104 und eine über einen Spannungsquellenanschluss VH_lim der Steuereinrichtung 104 verbundene Spannungsquelle 106. Die Steuereinrichtung weist zumindest den Spannungsquellenanschluss VH_lim, einen High-Side-Zündkreisanschluss IGH1, einen Low-Side-Zündkreisanschluss IGL1, einen Zündkreisverstärkungs-Anschluss ZKV, einen Offset-Anschluss ZKO, einen Analogmasseanschluss AGND sowie einen Digitalmasseanschluss DGND als Schnittstellen auf. Die Steuereinrichtung 104 ist über den High-Side-Zündkreisanschluss IGH1 mit einem ersten Versorgungsanschluss ZK1+ des Zündkreises 102 und über den Low-Side-Zündkreisanschluss IGL1 mit einem zweiten Versorgungsanschluss ZK1- des Zündkreises 102 verbunden.

Als Teil der Steuereinrichtung 104 ist zwischen dem Spannungsquellenanschluss VH_lim und dem High-Side-Zündkreisanschluss IGH1 ist eine High-Side-Stromquelle IH angeordnet. Dabei entspricht eine Leerlaufspannung der High-Side-Stromquelle IH zumindest dem Spannungsschwellwert. In einem günstigen Ausführungsbeispiel entspricht die Leerlaufspannung der High-Side-Stromquelle IH zumindest einer maximalen Zündspannung des Zündkreises.

Der zu messende Zündkreis 102 weist einen ersten Versorgungsanschluss ZK1+ und einen zweiten Versorgungsanschluss ZK1- auf. Diese sind über Steuergerät-Leiterbahnen mit dem entsprechenden High-Side-Zündkreisanschluss IGH1 beziehungsweise dem Low-Side-Zündkreisanschluss IGL1 der Steuereinrichtung 104 verbunden. Neben einem bisher bekannten (Steuereinrichtung 102) internen Zündkreis-Referenzwiderstand ZKR, der an den Zündkreisverstärkungs-Anschluss ZKV (ASIC-Pin ZKV) nach Masse zum automatischen Feinabgleich der linearen Messstromquellentoleranz von der Stromsenke IL und der Verstärkung des Messkanals (Instrumentenverstärker) angeschlossen ist, ist der weitere Offset-Anschluss ZKO (ASIC-PIN ZKO) direkt angeschlossen an die Steuergerätmasse zur Vermeidung von Offset-Fehlern des Instrumentenverstärkers.

Die High-Side-Stromquelle IH wird über den stromlimitierten Spannungsquellenanschluss VH_lim versorgt. Der stromlimitierte Spannungsquellenanschluss VH_lim wird auch als Anschluss für die High-Side-Stromquelle IH bezeichnet. Zur Strom-Limitierung ist ein zur Steuereinrichtung externer Strom-Limitierungswiderstand RH_lim beziehungsweise ASIC-externer Widerstand RH_lim gegen die höchste Airbagspannung VER der Energiereserve 106 geschaltet. Dieser begrenzt den Strom aus der Airbagspannung VER über eine defekte High-Side-Stromquelle IH gegen einen Nebenschluss insbesondere am Zündkreis 102.

Die Spannung VER ist die Ladespannung der Energiereserve aus der im Zündfall über einen ASIC externen Sicherheitshalbleiter (z. B. Schalttransistor) die Energie zum Aktivieren eines oder mehrerer Zündkreise über in Fig. 1 nicht dargestellte High- und Low-Side Endstufen je Zündkreis (in der Regel Bestandteil des Sytem-ASIC) erfolgt. Die High-Side Endstufe 1 ist an IGH1 angebunden, die Low-Side Endstufe 1 an IGL1.

Eine Stromsenke IL wird über den Spannungssenkenanschluss VL_lim nach Steuergerät-Masseanschluss Steuergerät-GND über einen ASIC-externen Widerstand RL_lim angebunden. Dieser begrenzt den durch einen Nebenschluss am Zündkreis 102 verursachten Strom gegen eine positive Fahrzeugspannung im Falle einer defekten Stromsenke IL. Der zeitliche Verlauf des Stromanstiegs beim Übergang von einem ersten Stromniveau auf ein zweites Stromniveau der High-Side-Stromquelle ICH wird durch eine Stromquellen-Steuereinrichtung Pulsformer_H als "Raised-Cosinus" vorgegeben. Durch eine beispielsweise 8-bit breite Stromprogrammierung kann die Einstellung des Messstromes in kleinen Hüben erfolgen.

Ein High-Side-Multiplexer IH-MUX verbindet die High-Side-Stromquelle IH mit dem High-Side-Zündkreisanschluss IGH1 für die Widerstandsmessung im Zündkreis 102 und mit dem Zündkreisverstärkungs-Anschluss ZKV sowie dem Offset-Anschluss ZKO zum Abgleich der Messeinrichtung. Ein Low-Side-Multiplexer IL-MUX verbindet die Stromquelle (Stromsenke) IL mit dem Low-Side-Zündkreisanschluss IGL1 für die Widerstandsmessung im Zündkreis 102 und mit dem Analogmasseanschluss AGND zum Abgleich der Messeinrichtung.

Mit der Verbindung zwischen dem High-Side-Zündkreisanschluss IGH1 und dem ersten Versorgungsanschluss ZK1+ ist ein mit Masse verbundener erster Zündkreiskondensator CH1 gekoppelt. Mit der Verbindung zwischen dem Low-Side-Zündkreisanschluss IGL1 und dem zweiten Versorgungsanschluss ZK1- ist ein mit Masse verbundener zweiter Zündkreiskondensator CL1 gekoppelt.

Ein IH-MUX-Ausgang des High-Side-Multiplexer IH-MUX kann über einen schaltbaren Terminierungswiderstand RHT (5kOhm ... 20kOhm) mit dem Spannungssenkenanschluss VL_lim verbunden werden. Dadurch lassen sich vor der Zündkreismessung eingekoppelte Ladungen auf den Zündkreiskondensatoren CH1/CL1 entladen. Ein durch die erhöhte Toleranz integrierter nicht abgeglichener Widerstände verursachter Messfehler wird durch Abschaltung des schaltbaren Terminierungswiderstand RHT mittels Schalter ST_H beseitigt.

Ein IL-MUX-Ausgang des Low-Side-Multiplexers IL-MUX kann über eine schaltbaren Terminierungswiderstand RLT (5kOhm ... 20kOhm) mit dem Spannungssenkenanschluss VL_lim verbunden werden. Dadurch lassen sich vor der Zündkreismessung eingekoppelte Ladungen auf den Zündkreiskondensatoren CL1/CH1 entladen. Ein durch die erhöhte Toleranz integrierter nicht abgeglichener Widerstände verursachter Messfehler wird durch Abschaltung des schaltbaren Terminierungswiderstand RLT mittels Schalter ST_L beseitigt.

Zur Digitalisierung der Messspannungen ist ein Analog-Digital-Wandler ADC vorgesehen, der über einen ADC-Multiplexer ADC_MUX die verschiedenen Spannungen, insbesondere die Spannungen eines Instrumentenverstärkers 108, zur Messung der Spannung zwischen dem High-Side-Zündkreisanschluss IGH1 und dem Low-Side-Zündkreisanschluss IGL1- für den Zündkreis 102 und zwischen Zündkreisverstärkungs-Anschluss ZKV und Analogmasseanschluss AGND beziehungsweise zwischen Offset-Anschluss ZKO und Analogmasseanschluss AGND zum Feinabgleich von Verstärkung und OFFSET über einen Tiefpass-Filter TP-FILTER erfasst.

Der Instrumentenverstärker 108 umfasst in einem Ausführungsbeispiel einen Tiefpassfilter. In einer Variante umfasst der Instrumentenverstärker 108 zumindest drei Operationsverstärker.

Zur Feststellung der Integrität der Strom-Limitierungswiderstände RH_lim und RL_lim werden die an dem Spannungsquellenanschluss VH_lim und dem Spannungssenkenanschluss VL_lim anliegenden Spannungen mit dem ADC-Multiplexer ADC_MUX über den Spannungsteiler Teiler_VH beziehungsweise den integrierten Schutzwiderstand R_VL verbunden.

Dargestellt sind Masseanschlüsse der Steuereinrichtung 102, die in der Regel aus einer/mehreren Digitalmasseanschlüssen DGND und einer/mehreren Analogmasseanschlüssen AGND bestehen. Nicht dargestellt ist ein Clock-Eingang für die digitalen Zustandsmaschinen (State-Maschines). Nicht dargestellt sind die Versorgungsspannungen der ASIC-Baugruppen, die je nach ASIC-Prozess benötigt werden.

Dargestellt sind ferner die abschaltbaren Spannungsteiler Teiler_H, Teiler_L zur Erfassung der Spannungspegel am ersten Versorgungsanschluss ZK1+ nach Masse beziehungsweise zweiten Versorgungsanschluss ZK1- nach dem Spannungssenkenanschluss VL_lim für die Low-Side-Stromsenke IL (limitierte Bezugsmasse). Dargestellt sind ebenfalls wichtige bekannte Blöcke wie Referenzstromerzeugung (beispielsweise für die Stromquellen), Referenzspannungserzeugung (beispielsweise für den Analog-Digital-Wandler ADC) sowie ASIC-Temperaturerfassung für die Kompensation von Temperatureffekten.

In dem in Fig. 1 dargestellten Ausführungsbeispiel umfasst die Steuereinrichtung 104 ein Steuergerät 110, welches im Folgenden auch als digitaler Block 110 bezeichnet wird. Das Steuergerät 110 schafft eine halbautomatische Zündkreis-Messsteuerung, Messwertverarbeitung und Fehlererkennung. In einem Bereich des Steuergeräts 110 können zumindest ein Messauftrag, ein Messergebnis und eine Programmierung der auszuführenden Verfahrensschritte hinterlegt werden. Dabei wird das Steuergerät 110 in einem Ausführungsbeispiel über einen SPI-Bus mit einem zu dem Steuergerät 110 externen Mikrocontroller μC oder Steuergerät-Mikrocontroller ECU-μC verbunden, um von dort Messaufträge zu erhalten und an diesen Messergebnisse zu übertragen.

Dargestellt ist der gesamte digitale Block 110, der über eine Schnittstelle zu einem steuergerät-internen Mikrocontroller μC verfügt. Der digitale Block 110 oder der digitale Block 110 zusammen mit dem Mikrocontroller μC wird auch als Steuergerät 110, ASIC-Steuerung 110 oder ASIC-Messwertverarbeitung 110 bezeichnet. Nach initialer Programmierung führt dieser nach Beauftragung die Zündkreismessung selbstständig durch.

In einem Ausführungsbeispiel sieht ein Ablauf einer Zündkreis Widerstandsmessung an dem Zündkreis 102 oder ZK1 wie folgt aus:

- Der Terminierungswiderstand RHT wird über den Schalter ST_H nach Steuergerät-Masseanschluss ECU-GND verbunden.
- Der Terminierungswiderstand RLT wird über den Schalter ST_L nach Steuergerät-Masseanschluss ECU-GND verbunden.
- Danach folgt eine Wartezeit von beispielsweise 5ms.
- Die ASIC-Steuerung 110 stellt den Multiplexer IH-MUX auf den High-Side-Zündkreisanschluss IGH1.
- Die ASIC-Steuerung 110 stellt den Multiplexer IL-MUX auf den Low-Side-Zündkreisanschluss IGL1.
- Die ASIC-Steuerung 110 stellt den Multiplexer ADC-MUX auf den Instrumentenverstärker 108.
- Die Stromsenke IL wird aktiviert und auf eine Stromlimitierung nach dem Spannungssenkenanschluss VL_lim von 60mA programmiert.
- Die High-Side-Stromquelle IH wird aktiviert und der Strom schrittweise mit einer "Raised Cosinus"-Flanke in beispielsweise 10 Schritten von beispielsweise 5mA auf 50mA erhöht.
- Der Schrittabstand beträgt beispielsweise 100μs.
- Nach Erreichen der finalen Messstromhöhe von 50mA werden die Terminierungswiderstände RHT, RLT durch die Schalter ST_H, ST_L abgeschaltet.
- Der Spannungsteiler Teiler_H und der Spannungsteiler Teiler_L werden von der limitierten Bezugsmasse beziehungsweise dem Spannungssenkenanschluss VL_lim abgeschaltet.
- Danach folgt eine Wartezeit von beispielsweise 1 ms (abhängig von der Tiefpass-Grenzfrequenz in der Messkette).
- Das Differenzspannungssignal zwischen dem High-Side-Zündkreisanschluss IGH1 und dem Low-Side-Zündkreisanschluss IGL1 wird nun über Tiefpassfilter TP-FILTER dem Instrumentenverstärker 108 mit einer Verstärkung von beispielsweise sechs zugeführt (das heißt einer sechsfachen Verstärkung) und das verstärkte und erneut tiefpass-gefilterte Ausgangssignal dem Analog-Digital-Wandler ADC zugeführt.

- Der Analog-Digital-Wandler ADC überträgt den digitalen Messwert in das Messwertregister der ASIC-Messwertverarbeitung 110.

Während die Messwertverarbeitung läuft, kann bereits mit der Messung des nächsten Zündkreis-Widerstands begonnen werden. Unter Kenntnis der Messstromhöhe der Verstärkung des Instrumentenverstärkers 108 errechnet die ASIC-Messwertverarbeitung 110 aus dem Analog-Digital-Wandler-Signal (ADC-Signal) den Zündkreiswiderstand.

Beispielsweise

ADC-Messwert = 400 Digit bei einer ADC-Referenzspannung von beispielsweise 3.75V und einem 10bit-Analog-Digital-Wandler ADC ergibt dies 3,666mV/Digit. Somit entsprechen 400 Digit einer Spannung von 1466,4mV. Mit einer sechsfachen Verstärkung ist die Spannungsdifferenz zwischen dem High-Side-Zündkreisanschluss IGH1 und dem Low-Side-Zündkreisanschluss IGL1 244,4mV. Bei einem nominalen Messstrom von 50mA ergibt dies einen Widerstand im Zündkreis n = 4,888 Ohm.

Durch einen der Messung vorausgehenden Feinabgleich lässt sich die Messgenauigkeit verbessern.

Feinabgleich-Ablauf, Schritt 1:

- Die ASIC-Steuerung 110 stellt den Multiplexer IH-MUX auf den Zündkreisverstärkungs-Anschluss ZKV.
- Die ASIC-Steuerung 110 stellt den Multiplexer IL-MUX auf Analogmasseanschluss AGND.
- Die ASIC-Steuerung110 stellt den ADC-Multiplexer ADC-MUX auf Instrumentenverstärker.
- Die High-Side-Stromquelle IH wird aktiviert und auf den Zielwert beispielsweise 50mA gestellt.
- Die Terminierungswiderstände RHT, RLT werden durch die Schalter ST_H, ST_L abgeschaltet.
- Der Spannungsteiler Teiler_H und der Teiler_L werden von der limitierten Bezugsmasse beziehungsweise dem Spannungssenkenanschluss VL_lim abgeschaltet.
- Danach folgt eine Wartezeit von beispielsweise 1 ms (abhängig von der Tiefpass-Grenzfrequenz in der Messkette).
- Das Differenzspannungssignal zwischen Zündkreisverstärkungs-Anschluss ZKV und Analogmasseanschluss AGND wird nun über Tiefpassfilter TP-FILTER dem Instrumentenverstärker 108 mit einer beispielsweise sechsfachen Verstärkung zugeführt und das verstärkte und erneut tiefpass-gefilterte Ausgangssignal dem Analog-Digital-Wandler ADC zugeführt.

- Der ADC-Messwert wird als Wert 1 (ADC_MW1) gespeichert.

Der ADC-Messwert Wert 1 (ADC_MW1) repräsentiert nun im Wesentlichen Folgendes:

$$IH \times ZKR \times V + OFFSET$$

Wobei IH = Messstrom ca. 50mA; V = Verstärkung der Verstärkungskette ca. 6; OFFSET der Verstärkungskette ca.20mV, ZKR = Zündkreis-Referenzwiderstand.

Feinabgleich Ablauf, Schritt 2:

- Die ASIC-Steuerung 110 stellt den Multiplexer IH-MUX auf Offset-Anschluss ZKO.
- Die ASIC-Steuerung 110 stellt den Multiplexer IL-MUX auf Analogmasseanschluss AGND.
- Die ASIC-Steuerung 110 stellt den Multiplexer ADC-MUX auf Instrumentenverstärker 108.
- Die High-Side-Stromquelle IH wird aktiviert und auf den Zielwert beispielsweise 50mA gestellt.
- Die Terminierungswiderstände RHT, RLT werden durch die Schalter ST_H, ST_L von dem limitierten Masse-Bezug beziehungsweise dem Spannungssenkenanschluss VL_lim abgeschaltet.
- Der Spannungsteiler Teiler_H und der Teiler_L werden von dem limitierten Masse-Bezug beziehungsweise dem Spannungssenkenanschluss VL_lim abgeschaltet.
- Danach folgt eine Wartezeit von beispielsweise 1 ms (abhängig von der Tiefpass-Grenzfrequenz in der Messkette).
- Das Differenzspannungssignal zwischen Offset-Anschluss ZKO und Analogmasseanschluss AGND wird nun über Tiefpassfilter TP-FILTER dem Instrumentenverstärker 108 mit einer beispielsweise sechsfachen Verstärkung zugeführt und das verstärkte und erneut tiefpass-gefilterte Ausgangssignal dem Analog-Digital-Wandler ADC zugeführt.
- Der ADC-Messwert wird als Wert 2 (ADC_MW2) gespeichert.

Der ADC-Messwert Wert 2 (ADC_MW2) repräsentiert nun im Wesentlichen Folgendes: OFFSET (OFFSET der Verstärkungskette ca. 20mV). Durch mathematische Operation folgt aus den Werten ADC_MW1 und ADC_MW2 und dem bekannten Referenzwiderstandswert ZKR beispielsweise 10 Ohm Folgendes: [ADC_MW1 - ADC_MW2] / ZKR = [IH x ZKR x V + OFFSET - OFFSET] / ZKR= IH x V.

Durch die nun vorliegenden Größen "OFFSET" und "Gesamtverstärkung" IH x V kann nun jede Widerstandsmessung fein abgeglichen werden. In dem obigen Beispiel beträgt der Zündkreis-Widerstandsmesswert (ohne Abgleich) 400 Digit entsprechend 4,88 Ohm.

Mit den Feinabgleichparametern OFFSET = 5 Digit; IH x V = 315 mA folgt: 400 Digit - 5 Digit = 395 Digit entspricht 1448 mV. Daraus folgt 1448 mV / 315 mA = 4,597 Ohm

Die Messwertverarbeitung prüft das Ergebnis gegen den maximal zulässigen Zündkreis-Widerstand und gegen den minimal zulässigen Zündkreis-Widerstand. Werden die Grenzen nicht eingehalten, erzeugt die Fehlerverarbeitung eine Fehlerinformation für den beauftragenden Mikrocontroller µC. Haben sich durch Umwelteinflüsse die Kontaktverbindungen im Zündkreis durch Oxidschichten verschlechtert, so wird im vorliegenden Ausführungsbeispiel beim Aufschalten der High-Side-Stromquelle IH die Feldstärke an der hochohmigen Oxidschicht erhöht, da die Leerlaufspannung der High-Side-Stromquelle IH bei keinen oder geringen Stromwerten trotz Vorschaltwiderstand RH_lim (Strom-Limitierungswiderstand RH_lim) ca. eine Spannung VER-3V, das heißt von größer 30 Volt (>=30V), erreichen kann. Die hohe Feldstärke ermöglicht einen Oxiddurchschlag und der einsetzende stromlimitierte Betrieb vermeidet Kontaktschäden im sich öffnenden Stromkanal. Durch zyklische Wiederholung des Messvorganges werden Kontaktfehler ausgeheilt.

Zur Überwachung der Strom-Limitierungswiderstände RH_lim und RL_lim wird bei jeder oder einer reduzierten Zahl von Zündkreis-Widerstandsmessungen zusätzlich zur Differenzspannungsmessung zwischen dem High-Side-Zündkreisanschluss IGH1 und dem Low-Side-Zündkreisanschluss IGL1 der Multiplexer ADC-MUX auch auf die Kanäle VH_lim und VL_lim beziehungsweise den Spannungsquellenanschluss VH_lim und den Spannungssenkenanschluss VL_lim gestellt. Der Erwartungswert beträgt für die Spannung am Spannungsquellenanschluss VH_lim: VH_lim = VER - RH_lim x IH, wobei VER für die Energiereservespannung oder die Ladespannung der Energiereserve , RH_lim für High-Side-Stromlimitierungswiderstand und IH für die eingestellte Stromstärke der High-Side-Stromquelle IH steht. Der Erwartungswert beträgt für die Spannung am Spannungssenkenanschluss VL_lim: VL_lim = RL_lim x IH, , wobei RL_lim für den Low-Side-Stromlimitierungswiderstand und IH für die eingestellte Stromstärke der High-Side-Stromquelle IH steht. In der Beispielrechnung repräsentiert VL_lim die Spannung am Spannungssenkenanschluss VL_lim. Weichen die Messergebnisse stärker als die Vorgabe vom Erwartungswert ab, erzeugt die Fehlerverarbeitung eine Fehlerinformation für den beauftragenden Mikrocontroller.

Im Folgenden werden die Bezugzeichen der Komponenten auch für deren Werte, das heißt Spannungen, Ströme oder Widerstände verwendet.

In einem Ausführungsbeispiel wird die High-Side-Stromquelle, die einen Messstrom zur Bestimmung des Zündkreiswiderstandes in der Regel 40mA .. 60mA auf der Zündkreis-High-Seite einspeist, über einen ASIC-externen Stromlimitierungswiderstand RH_lim an die hohe verpolgeschützte (Diode DH) Energiereservespannung 106 (24 ... 42 V) angeschlossen. Der Stromlimitierungswiderstand RH_lim zur verpolgeschützten Energiereservespannung ist dabei so dimensioniert, dass im Fall einer defekten (durchlegierten) High-Side-Stromquelle IH in der Steuereinrichtung 104 (das heißt, ein interner Steuergerätefehler), auch bei einem Kurzschluss im Zündkreis 102 gegen die Fahrzeugmasse (das heißt, ein externer Fehler) kein unzulässig hoher Strom über die Zündpille fließen kann (beispielsweise 100mA .. 150mA). Beispiel:

Mit VER=33V; VF=0,7V; IZKmax=125mA folgt RH_lim=32.3V/125mA=258 Ohm. VF ist dabei die Durchlass-Spg. Der Diode DH.

Die Low-Side-Stromsenke IL ist in einem Ausführungsbeispiel so dimensioniert, dass sie immer etwas mehr Strom senken kann, wie von der High-Side-Stromquelle IH über den ersten Versorgungsanschluss ZK+ und den Zündkreis an den zweiten Versorgungsanschluss zur Low-Side-Stromsenke IL rückgespeist wird, beispielsweise 50mA .. 70mA. Dabei ist ein Stromlimitierungswiderstand RL_lim zwischen dem Masseanschluss GND des Steuergeräts und der Low-Side-Stromsenke IL ASIC-extern einzufügen.

Für den Fall einer durchlegierten Low-Side-Stromsenke IL (das heißt, ein interner Steuergeräte-Fehler) muss der Strom durch die Zündpille auch bei einem Kurzschluss an dem ersten Versorgungsanschluss ZK+ nach Fahrzeug-Plus (6V ... 16.5V) (das heißt, ein externer Fehler) unter 100mA ... 150mA bleiben.

Beispiel:

Mit VER=16,5V; IZKmax=125mA folgt RL_lim=16,5V/125mA=132 Ohm.

Durch die hohe Leerlaufspannung der High-Side-Stromquelle IH mit beispielsweise 24V ... 42V können Kontaktoxide mit wesentlich höheren Durchschlags-Feldstärken belastet werden als heute. Wenn Kontakte aufgrund von Oxiden vorübergehend nicht leitfähig sind, so wird durch Aktivierung der High-Side-Stromquelle IH zunächst eine Spannung / Feldstärke an die Oxidschicht gebracht, wodurch diese besser durchschlagen werden kann. Tritt der Durchschlag ein, wird durch den limitierten Messstrom der Kontakt weiter in seiner Leitfähigkeit verbessert, ohne den Kanal zu überlasten (heilen).

Die externen Limitierungswiderstände RH_lim, RL_lim reduzieren zusätzlich die Verlustleistung der High-Side-Stromquelle IH während der regulären Widerstandsmessung mit Imess= IH=50mA (oder Imess in einem Bereich von 40 ... 60 mA) durch Reduktion der über der Stromquelle IH maximal auftretenden Spannung Vqmax.

Vqmax=VER-VF-Imess*(RH_lim+RL_lim)

z. B. 33V-0.7V-50Ma (258+132)$\Omega$=12.8V

Imess ist der Zündpillenmeßstrom der durch die Stromquelle IH, die Ströme der Größe IH=Imess erzeugt, falls keine Stromabflüsse durch Widerstände z. B. RHT, oder anderer Leckagen existieren.

Durch Überwachung der Spannung VH_lim beziehungsweise der Spannung VL_lim während der Zündkreis-Widerstandsmessung kann zusätzlich die Integrität der externen Limitierungswiderstände überprüft werden. VH_lim = VER - VF - Imess x RH_lim; beispielsweise VH_lim = 33V - 0,7V - 50mA x 258Ω = 19.4V. VL_lim= Imess x RL_lim; beispielsweise VL_lim = 132Ω x 50mA = 6.6V.

Durch Pulsformung beim Einschalten der High-Side-Messstromquelle wird ein Stromanstieg entsprechend der "Raised Cosine" Form erzeugt. Dadurch wird die Abstrahlung auf der bis zu 10m langen Zündkreisschleife im Fahrzeug reduziert. Durch stufenweise Erhöhung der Stromabgabe der Messstromquelle IH kann die Abstrahlung weiter verringert werden.

Die Differenzspannung zwischen dem ersten Versorgungsanschluss ZK+ und dem zweiten Versorgungsanschluss ZK- wird von einem Instrumentenverstärker erfasst. Dieser besitzt eine sehr hohe Gleichtaktunterdrückung ("Common Mode Rejection"), wodurch die Messung der durch den Messstrom an der Zündpille von typisch 100mV hervorgerufenen Differenzspannung zwischen dem ersten Versorgungsanschluss ZK+ und dem zweiten Versorgungsanschluss ZK- nicht durch die eine hohe OFFSET-Spannung (ca.6.6V) [verursacht durch den Limitierungswiderstand RL_lim an dem Spannungssenkenanschluss VL_lim] an dem ersten Versorgungsanschluss ZK+ und dem zweiten Versorgungsanschluss ZK- nach Steuergeräte-Masseanschluss (Steuergerät-GND) verfälscht wird.

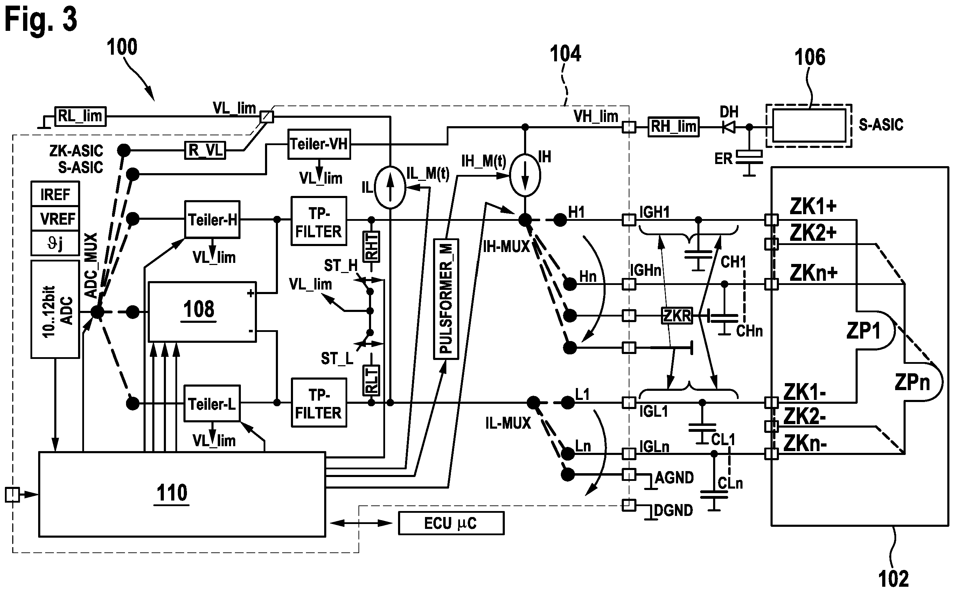

Zum Feinabgleich des bereits relativ präzisen Messstromes IH, das heißt einem Strom der High-Side-Stromquelle IH, (beispielsweise 10%), der relativ genauen Verstärkung V des Instrumentenverstärkers (beispielsweise 3%), des geringen OFFSETs (beispielsweise 10 ... 20 mV) ist neben dem bekannten steuergeräteinternen Zündkreiswiderstand ZKR (beispielsweise 10Ω, Messbereichsobergrenze) angeschlossen an den Zündkreisverstärkungs-Anschluss ZKV ein Offset-Anschluss ZKO verbunden mit dem Steuergerät-Masseanschluss GND sinnvoll. Durch diese Anschlüsse können der relevante Faktor IH x V und der OFFSET zu Beginn eines Messzyklus von n-Zündkreisen fein abgeglichen werden (siehe hierzu auch Fig. 3).

Durch Hinzunahme eines Leiterbahn-Abschnitts in den Steuergerät-Masseanschluss GND des Zündkreis-Referenzwiderstandes ZKR angeschlossen an den Zündkreisverstärkungs-Anschluss ZKV, welcher der Hinleitung und Rückleitung der Zündkreise auf der Leiterplatte vom ASIC 104 zum Gerätestecker entspricht und ebenso der Anbindung des Offset-Anschlusses ZKO (ASIC-PINS ZKO) nicht direkt nach Steuergerät-Masseanschluss (ECU-GND) sondern über ein Stück Leiterbahn, welches ebenfalls der Hinleitung und Rückleitung des Zündkreises auf der Leiterplatte entspricht, wird zusätzlich der immer wichtiger werdende von Temperatur und Leiterplatten-Herstellungstoleranzen schwankende Widerstand der Zündkreis-Anbindung vom Steuergerät-Stecker zum ASIC in der Zündkreis-Widerstandsmessung kompensiert.

In einem Ausführungsbeispiel wird die Anbindung des ersten Versorgungsanschlusses ZK1+ und des zweiten Versorgungsanschlusses ZK1-an den Instrumentenverstärker 108 als passiver Tiefpass erster Ordnung ausgeführt, um hohe Störfrequenzen fernzuhalten: (fg = 500kHz ... 1.5MHz). Der Instrumentenverstärker 108 selbst wird als aktiver Tiefpass von mindestens erster Ordnung ausgeführt: (fg = 1 kHz ... 10kHz).

Die High-Side-Stromquelle IH und Low-Side-Stromquelle IL mit externen Stromlimitierungswiderständen RH_lim, RL_lim lässt sich ebenso zur Bestimmung von Nebenschlüssen, insbesondere deren Innenwiderstände einsetzen, sofern Stromwerte in einem geeigneten Strombereich mit genügend kleiner Schrittweite einstellbar sind. Neu ist dabei ebenso wie bei der Zündkreis-Widerstandsmessung die Wirksamkeit gegen Kontaktoxide des Nebenschlusskreises durch Bereitstellung eines Potenzials an den Zündkreis-Klemmen höher als im Zündfall. Damit lässt sich eine Spannungslücke im Überwachungsband des Zündkreises von 0V bis über der maximalen ZündkreisSpannung im Auslösefall (beispielsweise 30V) ausschließen.

Zur Erhöhung der Robustheit gegen Einstrahlung kann der zumessende Zündkreis 102 durch einen ASIC-internen, das heißt innerhalb der Steuerungseinrichtung 104 angeordneten, schaltbaren Terminierungswiderstand nach Masse an dem Spannungssenkenanschluss VL_lim beschaltet werden. Dadurch bleibt die Sicherheit gegen Zündkreis-Spannungsfehler gewahrt, gleichzeitig verbessert sich die Robustheit der Messung durch Entladung der Zündkreis-Schleife vor der Messung.

Der Nachteil der reduzierten Messgenauigkeit durch einen nicht präzisen ASIC-internen Terminierungswiderstand wird durch Abschaltung unmittelbar vor der Messung beseitigt. Zur Erfassung von Nebenschluss-Innenwiderständen von 1 ... 20k Ohm sind die High-Side-Stromquelle/Low-Side-Stromsenke mit kleinen Stromschritten programmierbar ausgeführt.

Beispielsweise weist die High-Side-Stromquelle IH eine Schrittweite 250µA; 8bit Programmierung; maximal 63.75mA=255*250µA auf. Beispielsweise weist die Low-Side-Stromsenke IL eine Schrittweite 300 µA; 8bit Programmierung; maximal 76.5mA=255*300µA auf..

Optional kann zur Reduktion der Abstrahlung bezüglich Nebenschlussmessung diese so ausgeführt werden, dass neben einer High-Side-Stromquelle IH an dem ersten Versorgungsanschluss ZK+ auch eine Low-Side-Stromquelle IL an dem zweiten Versorgungsanschluss ZK- verwendet wird. Dadurch lassen sich bei der Nebenschlussmessung nach Masse GND im fehlerfreien Zustand der Zündkreise Ströme über die Zündkreis-Schleife zur Ladung der Zündkreiskapazität auf der Zündkreis-Seite weitestgehend vermeiden.

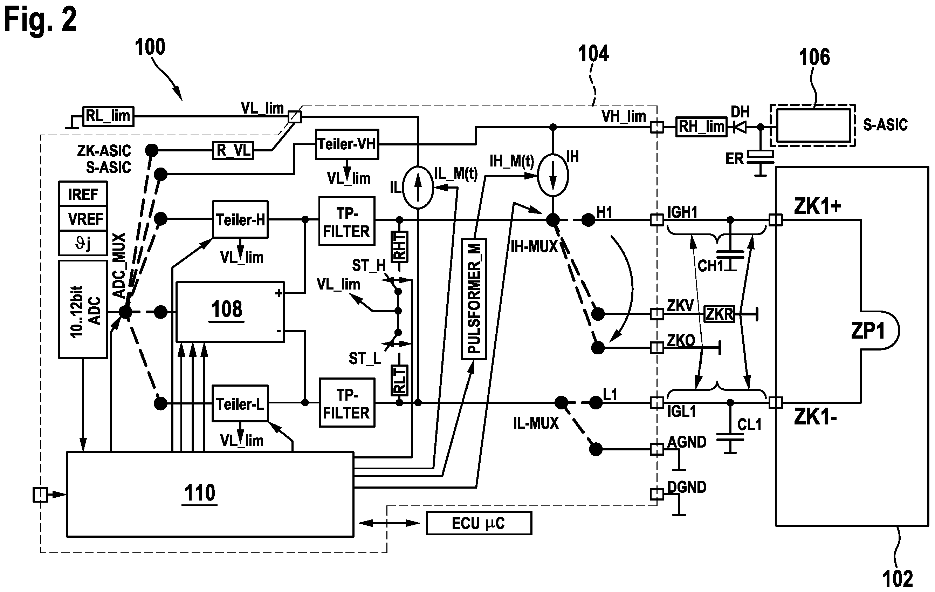

Fig. 2 zeigt einen vereinfachten Schaltplan einer Überwachungsvorrichtung 100 gemäß einem Ausführungsbeispiel der vorliegenden Erfindung. Die Darstellung in Fig. 2 entspricht weitgehend der Darstellung in Fig. 1, mit dem Unterschied der Beschaltung an dem Zündkreisverstärkungs-Anschluss ZKV und dem Offset-Anschluss ZKO.

In dem in Fig. 2 dargestellten Ausführungsbeispiel kann zusätzlich in den Masseanschluss des Zündkreis-Referenzwiderstandes ZKR eine Stück Leiterbahn geschaltet werden, welches der Hinleitung und Rückleitung des Zündkreises auf der Leiterplatte entspricht. Ebenso ist die Anbindung des Offset-Anschlusses ZKO nicht direkt nach Steuergerät-Masseanschluss ECU-GND auszuführen, sondern ebenfalls über ein Stück Leiterbahn welches ebenfalls der Hinleitung und Rückleitung des Zündkreises 102 auf der Leiterplatte entspricht. Mit dieser Maßnahme schließt der Feinabgleich auch die temperaturabhängige und in der durch Dicke und/oder Breite schwankenden Anbindung der Zündkreisanschlüsse über (Kupfer-) Leiterbahnen auf einer Leiterplatte zum Steuergerät-Gerätestecker mit ein. Dadurch ist es möglich sehr kompakte Steuergeräte zu bauen unter Ausnutzung minimaler Leiterbahnbreiten der Zündkreisanbindung.

Herkömmliche Geräte müssen die Leiterbahnbreite der Zündkreise 102 weit über die Stromtragfähigkeitsgrenze anheben, um die Widerstandswerte so niedrig zu halten, dass diese Schwankungen die Zündkreis-Widerstandsmessung nicht zu stark verfälschen. Dies bedeutet einen hohen Platzbedarf bei Airbag Systemen mit vielen Zündkreisen und eine unzureichende Verwendung von Leiterplatten-Innenlagen mit geringen Kupferdicken.

In dem in Fig. 2 dargestellten Ausführungsbeispiel kann Integritätsprüfung der Strom-Limitierungswiderstand RH_lim, RL_lim durchgeführt werden. Zur initialen Prüfung der Integrität des Limitierungswiderstands RH_lim wird der High-Side-Multiplexer IH_MUX auf den Offset-Anschluss ZKO gestellt und der ADC-Multiplexer ADC MUX auf den Spannungsteiler Teiler_VH. Der ADC-Messwert 1 (ADC_MW1) liefert die Spannung am Spannungsquellenanschluss VH_lim, diese entspricht im fehlerfreien Fall der Spannung VER-VF. Dann wird die High-Side-Stromquelle IH in Stufen mit Raised-Cosine-Stromanstieg auf beispielsweise 50 mA erhöht und erneut die Spannung am Spannungsquellenanschluss VH_lim über den Spannungsteiler mit dem Analog-Digital-Wandler ADC erfasst = ADC Messwert 2, beziehungsweise ADC_MW2. Durch die Berechnung (ADC_MW1 - ADC_MW2) / 50mA = RH_lim lässt sich der externe Limitierungswiderstand RH_lim auf seine zulässigen Grenzen prüfen.

Die Prüfung der Integrität des Limitierungswiderstands RL_lim kann im Zuge jeder Widerstandsmessung oder "verdünnt" bei jeder n-ten Widerstandsmessung ausgeführt werden. Hierzu wird ein spezifischer Messstrom verwendet, der an dem Spannungssenkenanschluss VL_lim eine ohne Spannungsteiler nur über einen Schutzwiderstand R_VL erfassbare Spannung liefert. Erreicht beim stufenweisen erhöhen die High-Side-Stromquelle IH den Wert beispielsweise IH=10mA wird der Spannungssenkenanschluss VL_lim über den Schutzwiderstand R_VL vom Analog-Digital-Wandler ADC gemessen als erster Messwert ADC_MW1. Daraus folgt ADC_MW1 / IH = RL_lim damit lässt sich der externe Limitierungswiderstand RL_lim auf seine zulässigen Grenzen prüfen.

Fig. 3 zeigt einen vereinfachten Schaltplan einer Überwachungsvorrichtung 100 gemäß einem Ausführungsbeispiel der vorliegenden Erfindung. Die Darstellung in Fig. 3 entspricht weitgehend der Darstellung in Fig. 2, wobei eine Mehrzahl von Zündkreisen 102 überwacht wird. Dargestellt sind ein erster Zündkreis ZK1, ein zweiter Zündkreis ZK2 sowie ein n-ter Zündkreis ZKn, mit entsprechenden Versorgungsanschlüssen ZK1+, ZK1-, ZK2+, ZK2-, ZKn+, ZKn- und den dazu korrespondierenden High-Side-Zündkreisanschlüssen IGH1 ... IGHn beziehungsweise Low-Side-Zündkreisanschlüssen IGL1 ... IGLn.

Das in Fig. 3 gezeigte Ausführungsbeispiel erweitert die Ausführungen der in Fig. 1 und Fig. 2 gezeigten Ausführungsbeispiele auf n Zündkreise. In Fig. 3 sind die relevanten Bereiche eines Airbag System-ASICs 102 oder Zündkreis-ASICs 102 dargestellt. Dieser soll die Zündkreis-Überwachung von n-Zündkreisen (ZKn) durchführen. Diese Zündkreise weisen jeweils einen ersten Versorgungsanschluss (ZKn+) und einen zweiten Versorgungsanschluss (ZK-) auf. Zusätzlich ist ein Steuergerät-interner (ECU-interner) ASIC-Anschluss zur OFFSET-Kompensation (Offset-Anschluss ZKO) vorgesehen. Der bekannte Verstärkungsabgleich erfolgt über den Zündkreisverstärkungs-Anschluss ZKV durch den Referenz-Zündkreiswiderstand ZKR.

Die Schaltungsanbindung an Offset-Anschluss ZKO und Zündkreisverstärkungs-Anschluss ZKV kann entsprechend den in den vorangegangenen Figuren Fig. 1 und Fig. 2 beschriebenen Ausführungsbeispielen erfolgen. Der Widerstand der externen Zündkreis-Schleifen ist zu bestimmen und einer Überwachung zuzuführen. Hierzu wird zusätzlich ein Feinabgleich entsprechend den vorausgegangenen Ausführungen durchgeführt um OFFSET und Gesamtverstärkung (IH x V) zu bestimmen.

Der High-Side-Multiplexer IH-MUX verbindet die High-Side-Stromquelle IH mit den High-Side-Zündkreisanschlüssen IGH1 ... IGHn, Offset-Anschluss ZKO, Zündkreisverstärkungs-Anschluss ZKV und, in Fig. 3 nicht dargestellt, zur erweiterten Nebenschlussmessung bei offenem Zündkreis auch mit den Low-Side-Zündkreisanschlüssen IGL1 ... IGLn. Der Low Side Multiplexer IL-MUX verbindet die Stromsenke IL mit den Low-Side-Zündkreisanschlüssen IGL1 ... IGLn und mit Analogmasseanschluss AGND zum Abgleich der Messeinrichtung sowie, in Fig. 3 nicht dargestellt, zur erweiterten Nebenschlussmessung bei offenem Zündkreis auch mit den High-Side-Zündkreisanschlüssen IGH1 ... IGHn.

Die High-Side-Stromquelle IH wird über den stromlimitierten Spannungsquellenanschluss VH_lim versorgt. Zur Strom-Limitierung ist ein ASIC externer Widerstand RH_lim verpolgeschützt an die höchste Airbag-Spannung VER der Energiereserve geschaltet. Dieser begrenzt den Strom aus der höchsten Airbag-Spannung VER über eine defekte High-Side-Stromquelle IH gegen einen Nebenschluss an einem der Zündkreise 1 .. n. Der Verpolschutz (Diode DH) lässt im Falle eines Zündkreiskurzschlusses nach Versorgung Plus keinen Reversstrom über eine als MOSFET ausgeführte High-Side Stromquelle IH zu.

Die Stromsenke IL wird über den Spannungssenkenanschluss VL_lim nach Steuergerät-Masseanschluss ECU-GND über den ASIC-externen Widerstand RL_lim angebunden. Dieser begrenzt den durch einen Nebenschluss an einem der Zündkreise 1 ...n verursachten Strom gegen die positive Fahrzeugspannung im Falle einer defekten Stromsenke. Der zeitliche Verlauf des Stromanstiegs beim Übergang von einem ersten Stromniveau auf ein zweites Stromniveau wird durch die Stromquellen-Steuereinrichtung Pulsformer_H und die Stromquellen-Steuereinrichtung Pulsformer_L als "Raised-Cosinus" vorgegeben. Durch eine beispielsweise 8-bit breite Stromprogrammierung kann die Einstellung des Messstromes in kleinen Hüben erfolgen.

Der IH-MUX-Ausgang kann über einen schaltbaren Terminierungswiderstand RHT (beispielsweise 5k Ohm ... 20k Ohm) mit dem Spannungssenkenanschluss VL_lim verbunden werden. Dadurch lassen sich vor der Zündkreismessung eingekoppelte Ladungen auf den Zündkreiskondensatoren entladen. Der Messfehler verursacht durch die erhöhte Toleranz integrierter, nicht abgeglichener Widerstände wird durch eine Abschaltung des Terminierungswiderstands RHT mittels Schalter ST_H beseitigt.

Der IL-MUX-Ausgang kann über eine schaltbaren Terminierungswiderstand RLT (beispielsweise 5k Ohm ... 20k Ohm) mit dem Spannungssenkenanschluss VL_lim verbunden werden. Dadurch lassen sich vor der Zündkreismessung eingekoppelte Ladungen auf den Zündkreiskondensatoren entladen. Der Messfehler verursacht durch die erhöhte Toleranz integrierter nicht abgeglichener Widerstände wird durch eine Abschaltung des Terminierungswiderstands RHT mittels Schalter ST_L beseitigt. Der IH-MUX Ausgang ist weiter mit einem Eingang eines passiven Tiefpassfilters TP-FILTER_H verbunden (beispielsweise fg = 500 kHz ... 1,5 MHz). Hier werden hochfrequente Zündkreis-Störungen von dem Plus-Eingang des Instrumentenverstärkers ferngehalten.

Der IL-MUX-Ausgang ist weiter mit einem Eingang eines passiven Tiefpassfilters TP-FILTER_L verbunden (beispielsweise fg = 500 kHz ... 1,5 MHz). Hier werden hochfrequente Zündkreis-Störungen von dem Minus-Eingang des Instrumentenverstärkers 108 ferngehalten.

Der Ausgang des passiven Tiefpassfilters TP-FILTER_H ist mit dem Plus-Eingang des Instrumentenverstärkers 108 verbunden. Der Ausgang des passiven Tiefpassfilters TP-FILTER_L ist mit dem Minus-Eingang des Instrumentenverstärkers 108 verbunden. Der Ausgang des passiven Tiefpassfilters TP-FILTER_H ist weiter mit einem Eingang eines programmierbaren Spannungsteilers TEILER_H verbunden, wobei der programmierbare Spannungsteiler TEILER_H einen Bezug auf den Spannungssenkenanschluss VL_lim aufweist, das heißt einen limitierten Masse-Bezug aufweist. Der Ausgang des passiven Tiefpassfilters TP-FILTER_L ist weiter mit dem Eingang eines programmierbaren Spannungsteilers TEILER L verbunden, wobei der programmierbare Spannungsteiler TEILER_L einen Bezug auf den Spannungssenkenanschluss VL_lim aufweist, das heißt einen limitierten Masse-Bezug aufweist. Die Spannungsteiler TEILER_H, TEILER_L passen den Messbereich des ASIC-internen Analog-Digital-Wandlers ADC von beispielsweise 0 ... 3,75 V an den externen Messspannungsbereich beispielsweise 0 ... 42 V an.

Die Teilerausgänge der Spannungsteiler TEILER_H, TEILER_L sind mit Eingängen des ADC-Multiplexers ADC-MUX verbunden. Ebenso ist der Instrumentenverstärker-Ausgang mit einem Eingang des ADC-Multiplexers ADC-MUX verbunden. Zur Feststellung der Integrität der Limitierungswiderstände RH_lim und RL_lim werden die Spannungen an dem Spannungsquellenanschluss VH_lim und dem Spannungssenkenanschluss VL_lim mit dem ADC-Multiplexer ADC_MUX über den Spannungsteiler Teiler_VH beziehungsweise über den integrierten Schutzwiderstand R_VL verbunden. Weitere für dieses Ausführungsbeispiel beziehungsweise diese Erweiterung nicht relevante Eingänge des Analog-Digital-Wandlers sind hier nicht dargestellt. Einfach-Fehler in den programmierbaren Teilern Teiler_H, Teiler_L, Teiler VH sind detektierbar und führen trotz Bezug auf den Steuergerät-Masseanschluss ECU-GND nicht zu kritischen Strömen in verbundenen Zündkreisen im Falle externer Zündkreis-Fehler nach Fahrzeug-Spannung, da mindestens zwei ASIC-interne Widerstände in Serie liegen.

Der Ausgang des ADC-Multiplexers ADC-MUX ist mit dem Eingang des Analog-Digital-Wandlers verbunden. Der Analog-Digital-Wandler liefert seine digitalen Spannungswerte an die halbautomatische Zündkreis-Messsteuerung 110 mit Verarbeitung und Fehlererkennung.

Die halbautomatische Zündkreis-Messsteuerung 110 wiederum erhält verschiedene Messaufträge über ein Interface zu einem ASIC-externen Mikrocontroller μC. Der Mikrocontroller μC erhält nach Abarbeitung des Messauftrages durch die Zündkreis-Messsteuerung 110, der Messwertverarbeitung und Fehlerbewertung das Ergebnis "Passed" oder "Not Passed" beziehungsweise "bestanden" oder "nicht bestanden". Über die Schnittstelle zum Mikrocontroller μC erfolgt ebenfalls die Programmierung der Messparameter, wie beispielsweise:

- Messstromhöhe und die Fehlergrenzen für die Zündkreis-Widerstandsmessung.
- Fehlergrenzen für die Zündkreis-Widerstandsmessung wie beispielsweise 1 Ohm für zu niedrig und 6,5 Ohm für zu hoch.
- Fehlergrenzen für die Widerstandsmessung im Referenz-Zündkreis.
- Fehlergrenzen für einen Nebenschluss im Referenz-Zündkreis.
- Die Innenwiderstandsmessung der Zündkreis-Nebenschlüsse nach Masse, oder Innenwiderstandsmessung der Zündkreis-Nebenschlüsse nach Fahrzeugspannung beispielsweise 3k Ohm für zu niedrig.
- Das Zündkreis-Spannungsniveau für Erkennung auf Nebenschluss nach Masse beziehungsweise nach Fahrzeugspannung.
- Fehlergrenzen für die Limitierungswiderstände RL_lim; RH_lim und die Spannungen VL_lim, VH_lim an den entsprechenden Anschlüssen Spannungssenkenanschluss VL_lim, Spannungsquellenanschluss VH_lim.
- Kennzeichnung der Zündkreise, die gemessen werden sollen.
- Angaben zur Messfrequenz.

In einem Ausführungsbeispiel weist eine Zündkreis Widerstandsmessung an einem Zündkreis ZKn den folgenden Ablauf auf:

- Der Terminierungswiderstand RHT wird über den Schalter ST_H nach dem Spannungssenkenanschluss VL_lim (limitierter Steuergerät-Masseanschluss ECU-GND) verbunden.
- Der Terminierungswiderstand RLT wird über den Schalter ST_L nach dem Spannungssenkenanschluss VL_lim (limitierter Steuergerät-Masseanschluss ECU-GND) verbunden.
- Danach folgt eine Wartezeit von beispielsweise 5ms.
- Die ASIC-Steuerung 110 stellt den Multiplexer IH-MUX auf den Anschluss IGHn.
- Die ASIC-Steuerung 110 stellt den Multiplexer IL-MUX auf den Anschluss IGLn.
- Die ASIC-Steuerung 110 stellt den ADC-Multiplexer ADC-MUX auf Instrumentenverstärker 108.
- Die Stromsenke IL wird aktiviert und auf eine Stromlimitierung nach dem Spannungssenkenanschluss VL_lim von 60mA programmiert.
- Die High-Side-Stromquelle IH wird aktiviert und der Strom schrittweise mit einer "Raised-Cosinus"-Flanke in beispielsweise zehn Schritten von beispielsweise 5 mA auf 50 mA erhöht.
- Der Schrittabstand beträgt beispielsweise 100 μs.

- Nach Erreichen der finalen Messstromhöhe von 50 mA werden die Terminierungswiderstände RHT, RLT durch die Schalter ST_H, ST_L von dem Spannungssenkenanschluss VL_lim abgeschaltet oder getrennt.
- Der Teiler_H und der Teiler_L werden von dem Spannungssenkenanschluss VL_lim abgeschaltet oder getrennt.
- Danach folgt eine Wartezeit von beispielsweise 1 ms (abhängig von der Tiefpass-Grenzfrequenz in der Messkette).
- Das Differenzspannungssignal zwischen den Anschlüssen IGHn und IGLn wird nun über Tiefpassfilter dem Instrumentenverstärker 108 mit einer beispielsweise sechsfachen Verstärkung zugeführt und das verstärkte und erneut tiefpass-gefilterte Ausgangssignal dem Analog-Digital-Wandler ADC zugeführt.
- Der Analog-Digital-Wandler ADC überträgt den digitalen Messwert (ADC-Messwert) in das Messwertregister der ASIC-Messwertverarbeitung 110. Während die Messwertverarbeitung 110 läuft, kann bereits mit der Messung des nächsten Zündkreis-Widerstands begonnen werden.
- Unter Kenntnis der Messstromhöhe und der Verstärkung des Instrumentenverstärkers 108 errechnet die ASIC-Messwertverarbeitung 110 aus dem Signal des Analog-Digital-Wandlers ADC den Zündkreiswiderstand.

In einem Ausführungsbeispiel beträgt der ADC-Messwert = 400 Digit (ADC Referenzspannung beispielsweise 3,75V; 10-bit-ADC ergibt 3,666mV/Digit). 400 Digit entspricht 1466,4mV. Mit einer sechsfachen Verstärkung ist die Spannungsdifferenz zwischen IGHn und IGLn 244,4mV. Bei einem nominalen Messstrom von 50mA ergibt sich ein Zündkreiswiderstand n = 4,888 Ohm.

Die Messgenauigkeit lässt sich wie in Fig. 1 und Fig. 2 beschrieben durch einen Feinabgleich verbessern.

Nach der Ermittlung des Zündkreiswiderstandes erfolgt eine Prüfung gegen vorgegebene Grenzen.

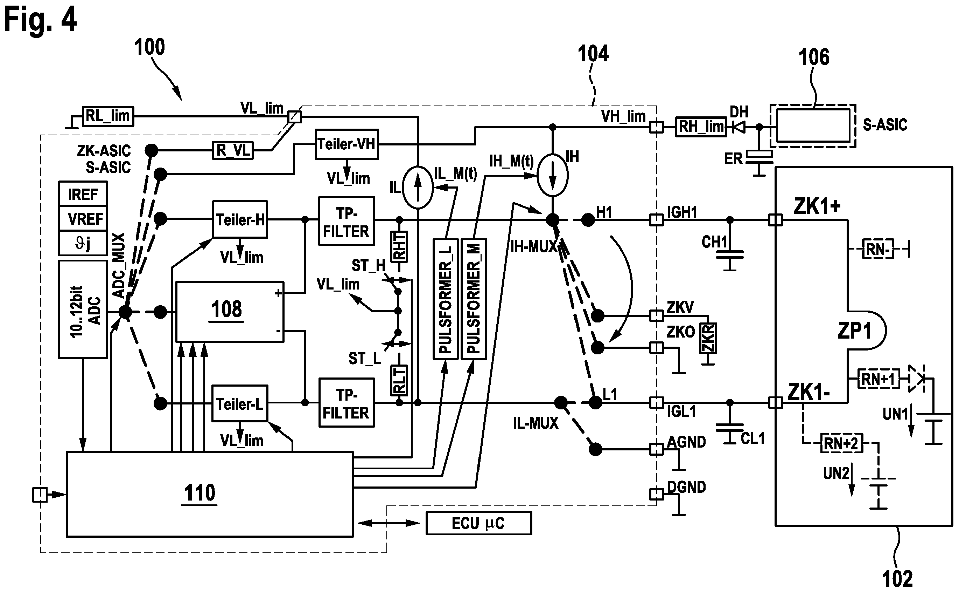

Fig. 4 zeigt einen vereinfachten Schaltplan einer Überwachungsvorrichtung 100 gemäß einem Ausführungsbeispiel der vorliegenden Erfindung. Das in Fig. 4 dargestellte Ausführungsbeispiel erweitert das in Fig. 1 dargestellte Ausführungsbeispiel zur Erfassung von Nebenschlüssen mit der programmierbaren High-Side-Stromquelle IH und der programmierbaren Stromsenke IL.

Zur Prüfung eines Nebenschlusses nach Masse GND an den ersten Versorgungsanschluss ZK1+ oder zweiten Versorgungsanschluss ZK1- wird die High-Side-Stromquelle IH Schritt für Schritt um 250 μA erhöht, bis die Spannung an dem ersten Versorgungsanschluss ZK1+ einen vorbestimmten Wert, beispielsweise 15V, erreicht hat: Dieser vorbestimmte Wert repräsentiert die maximale Zündkreisspannung gegen den Steuergerät-Masseanschluss ECU-GND im Zündfall bei maximalem Zündkreiswiderstand und Vorwärtsspannung einer Verkopplungsdiode. Der zum Erreichen dieses Wertes notwendige Strom wird erfasst (sofern kleiner als ca. 60 mA) und durch 15V/IH der Nebenschlusswiderstand RN- bestimmt.

Beispiel: IH=1 mA @ VH=15V, daraus folgt: Rn- =15 kΩ.

Handelt es sich um einen Nebenschluss gegen eine über eine Diode angekoppelte Spannung beispielsweise 12V, so springt die Spannung an dem ersten Versorgungsanschluss ZK1+ beim schrittweisen Erhöhen des Stromes der High-Side-Stromquelle IH um den Betrag der Nebenschlussspannung (hier UN1 = 12V) und steigt im Weiteren um IH x RN+1. In diesem Falle werden die Nebenschlussspannung UN1 und der Nebenschlusswiderstand RN+1 ermittelt und auf Fehlergrenzen geprüft.

Zur Prüfung eines Nebenschlusses nach Fahrzeug_Plus an dem ersten Versorgungsanschluss ZK1+ oder dem zweiten Versorgungsanschluss ZK1- wird zunächst die Spannung an dem ersten Versorgungsanschluss ZK1+ über den Spannungsteiler Teiler_H vom Analog-Digital-Wandler ADC erfasst (ADC_MW1) und danach die Stromsenke IL Schritt für Schritt um 300 μA erhöht, bis die ZK1+ Spannung an dem ersten Versorgungsanschluss ZK1+ den Wert von beispielsweise 3V erreicht hat: (Dieser Wert repräsentiert den maximalen Masseversatz zwischen Steuergerät-Masseanschluss ECU-GND und Chassis GND) mit [ADC_MW1 - ADC_MW2 (ca.3V)] / IL (@ZK1+ ca.3V) = RN+ wird der Nebenschlusswiderstand RN+2 nach Fahrzeug_Plus ermittelt. Der Spannungswert ADC_MW1 repräsentiert die Nebenschlussspannung UN2.

Ein Aspekt der vorgestellten Zündkreisüberwachung ist die Verwendung einer relativ betrachtet hohen Messspannung, einer gestuften Stromerhöhung sowie einer Flankenformung durch geeignete Steuergeräte. Dabei sind spezielle Schaltungselemente zur Erhöhung der Sicherheit und zur Erhöhung der Genauigkeit vorgesehen.

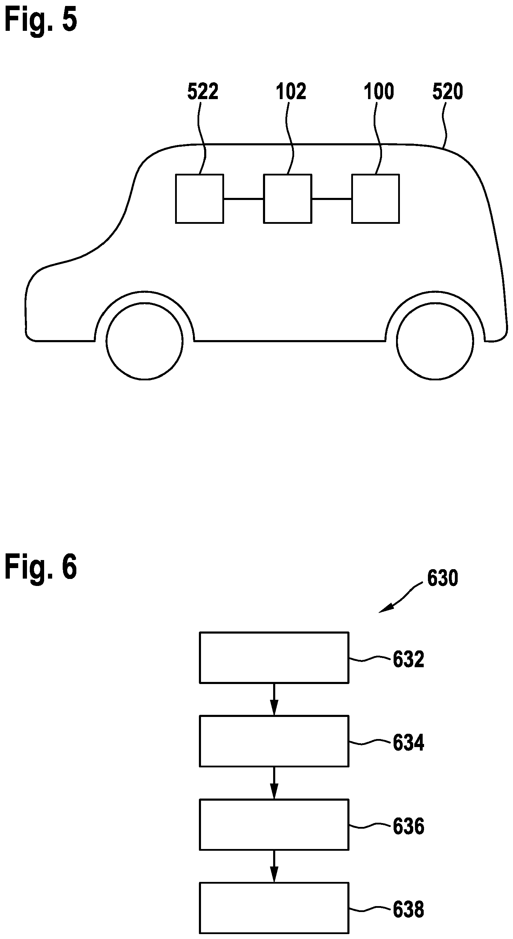

Fig. 5 zeigt eine schematische Darstellung eines Fahrzeugs 520 mit einem Personenschutzmittel 522 und einer Überwachungsvorrichtung 100 gemäß einem Ausführungsbeispiel der vorliegenden Erfindung. Das in Fig. 5 dargestellte Fahrzeug 500 weist ein Personenschutzmittel 522 wie einen Airbag 522 auf, das über einen Zündkreis 102 auslösbar ist. Der Zündkreis 102 ist von der Überwachungsvorrichtung 100 überwachbar. Dabei kann es sich bei der Überwachungsvorrichtung 100 um eine Variante einer in den vorangegangenen Figuren gezeigten Überwachungsvorrichtung 100 handeln.

Fig. 6 zeigt ein Ablaufdiagramm eines Verfahrens 630 gemäß einem Ausführungsbeispiel der vorliegenden Erfindung. Das Verfahren zum Betreiben einer Variante einer in Fig. 1 bis Fig. 5 beschriebenen Überwachungsvorrichtung umfasst in dem in Fig. 6 dargestellten Ausführungsbeispiel einen Schritt 632 des Verbindens, in dem der High-Side-Zündkreisanschluss IGH1 mit der High-Side-Stromquelle IH und der Low-Side-Zündkreisanschluss IGL1 mit einem Spannungssenkenanschluss VL_lim verbunden wird. In einem darauf folgenden Schritt 634 des Aktivierens wird die High-Side-Stromquelle IH aktiviert. In einem auf den Schritt 634 des Aktivierens folgenden Schritt 636 des Bestimmens wird ein Differenzspannungssignal zwischen dem High-Side-Zündkreisanschluss IGH1 und dem Low-Side-Zündkreisanschluss IGL1 bestimmt, welches in einem abschließenden Schritt 638 des Ermittelns verwendet wird, um einen Zündkreiswiderstand zu ermitteln.

Das Verfahren 630 zum Betreiben der Überwachungsvorrichtung kann durch einzelne in der Beschreibung zu Fig. 1 bereits dargestellte Verfahrensschritte erweitert werden. Dies ist auch teilweise von der Variante der angesteuerten Überwachungsvorrichtung abhängig. Das Verfahren 630 kann in einem Ausführungsbeispiel in Fig. 1 bis Fig. 4 dargestellten digitalen Block 110, beziehungsweise dem Steuergerät 110 ausgeführt werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

**Patentansprüche**

1. Überwachungsvorrichtung (100) für zumindest einen Zündkreis (102) für ein Personenschutzmittel (522) für ein Fahrzeug (520), wobei der zumindest eine Zündkreis (102) ausgebildet ist, das Personenschutzmittel (522) bei Anliegen einer einen Spannungsschwellwert übersteigenden Zündspannung und/oder eines einen Stromschwellwert übersteigenden Zündstroms zu aktivieren, wobei die Überwachungsvorrichtung (100) eine Steuereinrichtung (104) und eine über einen Spannungsquellenanschluss (VH_lim) der Steuereinrichtung (104) verbundene Spannungsquelle (106) aufweist, wobei die Steuereinrichtung (104) über einen High-Side-Zündkreisanschluss (IGH1) mit einem ersten Versorgungsanschluss (ZK1+) des Zündkreises (102) und über einen Low-Side-Zündkreisanschluss (IGL1) mit einem zweiten Versorgungsanschluss (ZK1-) des Zündkreises (102) verbunden ist, **dadurch gekennzeichnet, dass**

die Überwachungsvorrichtung (100) derart ausgebildet ist, dass eine Leerlaufspannung einer zwischen dem Spannungsquellenanschluss (VH_lim) und dem High-Side-Zündkreisanschluss (IGH1) angeordneten High-Side-Stromquelle (IH) der Steuereinrichtung (104) zumindest dem Spannungsschwellwert entspricht, insbesondere dass die Leerlaufspannung zumindest einer maximalen Zündspannung des Zündkreises entspricht.

2. Überwachungsvorrichtung (100) gemäß Anspruch 1, bei der die Leerlaufspannung der High-Side-Stromquelle (IH) zumindest 26 Volt, insbesondere zumindest 30 Volt, insbesondere zumindest 42 Volt beträgt.

3. Überwachungsvorrichtung (100) gemäß einem der vorangegangenen Ansprüche, mit einer Stromquellen-Steuereinrichtung (Pulsformer_H), die ausgebildet ist, einen zeitlichen Verlauf eines Stromanstiegs der High-Side-Stromquelle (IH) beim Übergang von einem ersten Stromniveau auf ein zweites Stromniveau entsprechend einer vordefinierten Übergangsform zu steuern, insbesondere den zeitlichen Verlauf des Stromanstiegs entsprechend einer Übergangsform mit einem Verlauf eines "Raised-Cosinus" zu steuern.

4. Überwachungsvorrichtung (100) gemäß einem der vorangegangenen Ansprüche, mit einer Filtereinrichtung zum Filtern zumindest einer Messspannung, insbesondere wobei die Filtereinrichtung zumindest einen Tiefpassfilter (TP-FILTER) umfasst.

5. Überwachungsvorrichtung (100) gemäß einem der vorangegangenen Ansprüche, mit einem Analog-Digital-Wandler (ADC), der über einen ADC-Multiplexer (ADC_MUX) mit einem Instrumentenverstärker (108), zur Messung einer Spannung über einen Tiefpassfilter (TP-FILTER) zwischen dem High-Side-Zündkreisanschluss (IGH1) und dem Low-Side-Zündkreisanschluss (IGL1) für den zumindest einen Zündkreis (102) und zwischen einem Zündkreisverstärkungs-Anschluss (ZKV) und Analogmasseanschluss (AGND) beziehungsweise zwischen einem Offset-Anschluss (ZKO) und dem Analogmasseanschluss (AGND).

6. Überwachungsvorrichtung (100) gemäß einem der vorangegangenen Ansprüche, mit einem Strom-Limitierungswiderstand (RH_lim) zwischen der Spannungsquelle (106) und dem Spannungsquellenanschluss (VH_lim) und/oder einem Strom-Limitierungswiderstand (RL_lim) zwischen dem Masseanschluss und einem Spannungssenkenanschluss (VL_lim).

7. Überwachungsvorrichtung (100) gemäß einem der vorangegangenen Ansprüche, mit einem schaltbaren High-Side-Terminierungswiderstand (RHT) und/oder einem schaltbaren Low-Side-Terminierungswiderstand (RLT), insbesondere mit einem zwischen einem Ausgang eines mit der High-Side-Stromquelle (IH) verbundenen High-Side-Multiplexers (IH-MUX) und dem Spannungssenkenanschluss (VL_lim) angeordneten schaltbaren High-Side-Terminierungswiderstand (RHT) und/oder einem zwischen einem Ausgang eines mit dem Low-Side-Zündkreisanschluss (IGL1) verbundenen Low-Side-Multiplexers (IL-MUX) und dem Spannungssenkenanschluss (VL_lim) angeordneten schaltbaren Low-Side-Terminierungswiderstand (RLT).

8. Überwachungsvorrichtung (100) gemäß einem der vorangegangenen Ansprüche, mit einem schaltbaren High-Side-Spannungsteiler (Teiler_H) und/oder einem schaltbaren Low-Side-Spannungsteiler (Teiler_L), insbesondere mit einem zwischen einem Ausgang eines mit der High-Side-Stromquelle (IH) verbundenen High-Side-Multiplexers (IH-MUX) und einem mit einem Analog-Digital-Wandler (ADC) verbundenen ADC-Multiplexer (ADC-MUX) angeordneten schaltbaren High-Side-Spannungsteiler (Teiler_H) und/oder einem zwischen einem Ausgang eines mit dem Low-Side-Zündkreisanschluss (IGL1) verbundenen Low-Side-Multiplexers (IL-MUX) und dem ADC-Multiplexer (ADC-MUX) angeordneten schaltbaren Low-Side-Spannungsteiler (Teiler_L).

9. Überwachungseinrichtung (100) gemäß einem der vorangegangenen Ansprüche , mit einer Verpolschutzdiode zwischen VH_lim und einer Ausgangskapazität der Spannungsquelle (106) in Serie zum Strom-Limitierungswiderstand (RH_lim).

10. Verfahren (630) zum Betreiben einer Überwachungsvorrichtung (100) gemäß einem der vorangegangenen Ansprüche, wobei das Verfahren (630) zumindest die folgenden Schritte aufweist:

Verbinden (632) von High-Side-Zündkreisanschluss (IGH1) mit der High-Side-Stromquelle (IH) und Verbinden von Low-Side-Zündkreisanschluss (IGL1) mit einem Spannungssenkenanschluss (VL_lim);
Aktivieren (634) der High-Side-Stromquelle (IH);
Bestimmen (636) eines Differenzspannungssignals zwischen dem High-Side-Zündkreisanschluss (IGH1) und dem Low-Side-Zündkreisanschluss (IGL1); und

Ermitteln (638) eines Zündkreiswiderstands unter Verwendung des Differenzspannungssignals.

11. Steuergerät (110), das ausgebildet ist, um alle Schritte eines Verfahrens (630) gemäß Anspruch 10 durchzuführen.

12. Computerprogramm, das dazu eingerichtet ist, alle Schritte eines Verfahrens (630) gemäß Anspruch 10 durchzuführen.

13. Maschinenlesbares Speichermedium mit einem darauf gespeicherten Computerprogramm nach Anspruch 10.

**Claims**

1. Monitoring apparatus (100) for at least one ignition circuit (102) for personal protection means (522) for a vehicle (520), wherein the at least one ignition circuit (102) is designed to activate the personal protection means (522) when an ignition voltage exceeding a voltage threshold value and/or an ignition current exceeding a current threshold value is applied,
wherein the monitoring apparatus (100) has a control device (104) and a voltage source (106) connected by means of a voltage source terminal (VH_lim) of the control device (104), wherein the control device (104) is connected to a first supply terminal (ZK1+) of the ignition circuit (102) by means of a high-side ignition circuit terminal (IGH1) and to a second supply terminal (ZK1-) of the ignition circuit (102) by means of a low-side ignition circuit terminal (IGL1), **characterized in that**
the monitoring apparatus (100) is designed in such a way that a no-load voltage of a high-side current source (IH) of the control device (104), which high-side current source is arranged between the voltage source terminal (VH_lim) and the high-side ignition circuit terminal (IGH1), corresponds at least to the voltage threshold value, in particular in such a way that the no-load voltage corresponds at least to a maximum ignition voltage of the ignition circuit.

2. Monitoring apparatus (100) according to Claim 1, in which the no-load voltage of the high-side current source (IH) is at least 26 volts, in particular at least 30 volts, in particular at least 42 volts.

3. Monitoring apparatus (100) according to either of the preceding claims, having a current source control device (Pulsformer_H), which is designed to control a time profile of a current rise of the high-side current source (IH) during the transition from a first current level to a second current level in accordance with a predefined transition form, in particular to control the time profile of the current rise in accordance with a transition form having a profile of a "raised cosine".

4. Monitoring apparatus (100) according to one of the preceding claims, having a filter device for filtering at least one measurement voltage, in particular wherein the filter device comprises at least one low-pass filter (TP-FILTER).

5. Monitoring apparatus (100) according to one of the preceding claims, having an analogue-to-digital converter (ADC), which to an instrumentation amplifier (108) by means of an ADC multiplexer (ADC_MUX), for measuring a voltage across a low-pass filter (TP-FILTER) between the high-side ignition circuit terminal (IGH1) and the low-side ignition circuit terminal (IGL1) for the at least one ignition circuit (102) and between an ignition circuit amplifying terminal (ZKV) and analogue earth terminal (AGND) and respectively between an offset terminal (ZKO) and the analogue earth terminal (AGND).

6. Monitoring apparatus (100) according to one of the preceding claims, having a current limiting resistor (RH_lim) between the voltage source (106) and the voltage source terminal (VH_lim) and/or having a current limiting resistor (RL_lim) between the earth terminal and a voltage sink terminal (VL_lim).

7. Monitoring apparatus (100) according to one of the preceding claims, having a switchable high-side terminating resistor (RHT) and/or a switchable low-side terminating resistor (RLT), in particular having a switchable high-side terminating resistor (RHT) arranged between an output of a high-side multiplexer (IH-MUX) connected to the high-side current source (IH) and the voltage sink terminal (VL_lim) and/or a switchable low-side terminating resistor (RLT) arranged between an output of a low-side multiplexer (IL-MUX) connected to the low-side ignition circuit terminal (IGL1) and the voltage sink terminal (VL_lim).

8. Monitoring apparatus (100) according to one of the preceding claims, having a switchable high-side voltage divider (Teiler_H) and/or a switchable low-side voltage divider (Teiler_L), in particular having a switchable high-side voltage divider (Teiler_H) arranged between an output of a high-side multiplexer (IH-MUX) connected to the high-side current source (IH) and an ADC multiplexer (ADC-MUX) connected to an analogue-to-digital converter (ADC) and/or a switchable low-side voltage divider (Teiler_L) arranged between an output of a low-side multiplexer (IL-MUX) connected to the low-side ignition circuit terminal (IGL1) and the ADC multiplexer (ADC-MUX).

**9.** Monitoring device (100) according to one of the preceding claims, having a polarity-reversal protection diode between VH_lim and an output capacitance of the voltage source (106) in series with the current limiting resistor (RH_lim).

**10.** Method (630) for operating a monitoring apparatus (100) according to one of the preceding claims, wherein the method (630) comprises at least the following steps:

connecting (632) high-side ignition circuit terminal (IGH1) to the high-side current source (IH) and connecting low-side ignition circuit terminal (IGL1) to a voltage sink terminal (VL_lim);
activating (634) the high-side current source (IH);
determining (636) a difference voltage signal between the high-side ignition circuit terminal (IGH1) and the low-side ignition circuit terminal (IGL1); and
identifying (638) an ignition circuit resistance using the difference voltage signal.

**11.** Control unit (110), which is designed to carry out all of the steps of a method (630) according to Claim 10.

**12.** Computer program, which is designed to carry out all of the steps of a method (630) according to Claim 10.

**13.** Machine-readable storage medium having a computer program according to Claim 10 stored thereon.

**Revendications**

**1.** Ensemble de surveillance (100) pour au moins un circuit d'allumage (102) d'un moyen (522) de protection des personnes d'un véhicule (520), le ou les circuits d'allumage (102) étant configurés pour activer le moyen (522) de protection des personnes lors de l'application d'une tension d'allumage qui dépasse une valeur de seuil de tension et/ou d'un courant d'allumage qui dépasse un seuil de courant, l'ensemble de surveillance (100) présentant un dispositif de commande (104) et une source de tension (106) reliée au dispositif de commande (104) par l'intermédiaire d'une borne (VH_lim) de source de tension, le dispositif de commande (104) étant relié par une borne (IGH1) de côté haut du circuit d'allumage à une première borne d'alimentation (ZK1+) du circuit d'allumage (102) et par une borne (IGL1) de côté bas du circuit d'allumage à une deuxième borne d'alimentation (ZK1-) du circuit d'allumage (102), **caractérisé en ce que**

l'ensemble de surveillance (100) est configuré de telle sorte qu'une tension à vide d'une source (IH) de courant côté haut du dispositif de commande (104) disposée entre la borne (VH_lim) de source de tension et la borne (IGH1) de côté haut du circuit d'allumage corresponde au moins à la valeur de seuil de tension et en particulier **en ce que** la tension à vide corresponde au moins à une tension maximale d'allumage du circuit d'allumage.

**2.** Ensemble de surveillance (100) selon la revendication 1, dans lequel la tension à vide de la source (IH) de courant côté haut vaut au moins 26 volts, en particulier au moins 30 volts et notamment au moins 42 volts.

**3.** Ensemble de surveillance (100) selon l'une des revendications précédentes, présentant un dispositif (Pulsformer_H) de commande de la source de courant configuré pour commander l'évolution dans le temps de l'augmentation du courant de la source (IH) de courant côté haut lors du passage d'un premier niveau de courant à un deuxième niveau de courant en correspondance à une forme de transition prédéfinie, et en particulier pour commander l'évolution dans le temps de l'augmentation du courant en correspondance à une forme de transition dont l'évolution correspond à un "cosinus augmenté".

**4.** Ensemble de surveillance (100) selon l'une des revendications précédentes, doté d'un dispositif de filtrage qui filtre au moins une tension de mesure, le dispositif de filtrage comprenant en particulier au moins un filtre passe-bas (TP-FILTER).

**5.** Ensemble de surveillance (100) selon l'une des revendications précédentes, présentant un convertisseur analogique-numérique (ADC) par un convertisseur analogique-numérique (ADC_MUX) à un amplificateur d'instrument (108) pour la mesure d'une tension par l'intermédiaire d'un filtre passe-bas (TP-FILTER) entre la borne (IGH1) de côté haut du circuit d'allumage et la borne (IGL1) de côté bas pour le ou les circuits d'allumage (102) et entre une borne (ZKV) d'amplification de circuit d'allumage et une borne de masse analogique (AGND), ou entre une borne de décalage (ZKO) et la borne de masse analogique (AGND).

**6.** Ensemble de surveillance (100) selon l'une des revendications précédentes, présentant une résistance (RH_lim) de limitation du courant entre la source de tension (106) et la borne (VH_lim) de source de tension et/ou une résistance (RL_lim) de limitation du courant entre la borne de masse et une borne (VL_lim) d'abaissement de la tension.

**7.** Ensemble de surveillance (100) selon l'une des revendications précédentes, présentant une résistance commutable (RHT) de terminaison côté haut et/ou une résistance commutable (RLT) de terminaison côté bas, et en particulier une résistance commutable (RHT) de terminaison côté haut disposée entre une sortie d'un multiplexeur côté haut (IH-MUX) relié à la source (IH) de courant côté haut et la borne (VL_lim) d'abaissement de la tension et/ou une résistance commutable (RLT) de terminaison côté bas disposée entre une sortie d'un multiplexeur (IL-MUX) côté bas relié à la borne (IGL1) de côté bas et la borne (VL_lim) d'abaissement de la tension.

8. Ensemble de surveillance (100) selon l'une des revendications précédentes, présentant un diviseur de tension commutable (Teiler_H) côté haut et/ou un diviseur de tension commutable (Teiler_L) côté bas, et en particulier un diviseur de tension commutable (Teiler_H) côté haut disposé entre une sortie d'un multiplexeur (IH-MUX) côté haut raccordé à la source (IH) de courant côté haut et un multiplexeur ADC (ADC-MUX) relié à un convertisseur analogique-numérique (ADC) et/ou un diviseur de tension commutable (Teiler_L) côté bas disposé entre une sortie d'un multiplexeur (IL-MUX) côté bas relié à la borne (IGL1) de côté bas et le convertisseur analogique-numérique (ADC-MUX).

9. Ensemble de surveillance (100) selon l'une des revendications précédentes, présentant une diode de protection contre l'inversion de polarisation disposée entre VH_lim et une capacité de sortie de la source de tension (106) en série avec la résistance (RH_lim) de limitation du courant.

10. Procédé (630) de conduite d'un ensemble de surveillance (100) selon l'une des revendications précédentes, le procédé (630) comportant au moins les étapes suivantes :

raccordement (632) d'une borne (IGH1) de côté haut du circuit d'allumage à la source (IH) de courant côté haut et raccordement de la borne (IGL1) de côté bas à une borne (VL_lim) d'abaissement de la tension,
activation (634) de la source (IH) de courant côté haut,
détermination (636) d'un signal de tension différentielle entre la borne (IGH1) de côté haut du circuit d'allumage et la borne (IGL1) de côté bas et
détermination (638) d'une résistance du circuit d'allumage en recourant au signal de tension différentielle.

11. Appareil de commande (110) configuré pour mettre en oeuvre toutes les étapes d'un procédé (630) selon la revendication 10.

12. Programme informatique conçu pour exécuter toutes les étapes d'un procédé (630) selon la revendication 10.

13. Support de mémoire lisible par machine, sur lequel est conservé un programme informatique selon la revendication 10.

Fig. 1

**Fig. 2**

EP 3 233 578 B1

Fig. 3

# Fig. 4

EP 3 233 578 B1

## Fig. 5

## Fig. 6